# EUROPEAN PATENT APPLICATION

(11) **EP 4 844 801 A1**
(43) Date of publication of application: **25.11.2026**
(21) Application number: 25741966.3
(22) Date of filing: 15.01.2025
(51) Int. Cl.: H01J 1/16, H01J 9/04, H01J 37/36

(54) **EMITTER**

(30) Priority: 19.01.2024 JP 2024006768
(71) Applicant: Denka Company Limited, Tokyo 103-8338 (JP)
(72) Inventor: ISHIKAWA, Daisuke, Tokyo 103-8338 (JP)
(74) Representative: Hoffmann Eitle
(86) International application number: PCT/JP2025/001035
(87) International publication number: WO 2025/154741

(57) **Abstract**

An emitter comprises: an electron source; and a heater for heating the electron source. The electron source has: an electron-emitting member formed from a first material; and an enclosing member formed from a second material having a greater work function than the first material. The electron-emitting member has a first section and a second section formed integrally with the first section. The enclosing member is fixed to the electron-emitting member and encloses the first section when viewed from a prescribed direction. The enclosing member has a minimum thickness of 20 µm or more. The heater is in contact with the second section.

## Description

### TECHNICAL FIELD

One aspect of the present disclosure relates to an emitter.

### BACKGROUND

For example, Patent Document 1 describes an emitter provided with an electron source and a heater. In this emitter, the electron source is provided with a columnar portion that has electron emission characteristics and an electron emission limiting member that is disposed so as to surround the columnar portion. The heater is in contact with the electron emission limiting member and heats the columnar portion via the electron emission limiting member. The heated columnar portion emits electrons.

### CITATION LIST

### PATENT LITERATURE

Patent Document 1: WO 2021/215335 A1

### SUMMARY OF INVENTION

### TECHNICAL PROBLEM

In the emitter described above, it is preferable for there to be few fluctuations in the electron emission characteristics. In addition, it is preferable to effectively suppress the generation of excessive electrons, and structural stability is preferable.

Therefore, an object of one aspect of the present disclosure is to provide an emitter that can suppress fluctuations in electron emission characteristics and that allows for the effective suppression of the generation of excessive electrons and the improvement of structural stability.

### SOLUTION TO PROBLEM

An emitter according to one aspect of the present disclosure is [1] "an emitter provided with: an electron source and a heater for heating the electron source, wherein the electron source has an electron-emitting member that is formed of a first material and an enclosing member that is formed of a second material having a work function greater than that of the first material, the electron-emitting member has a first section, and a second section that is formed integrally with the first section, the enclosing member is fixed to the electron-emitting member and encloses the first section when viewed from a prescribed direction, the enclosing member has a minimum thickness of 20 µm or more, and the heater is in contact with the second section."

In this emitter, the first section of the electron-emitting member is enclosed by the enclosing member formed of the second material having a work function greater than that of the first material forming the electron-emitting member. Due to this, the generation of excessive electrons from areas other than the tip section of the first section can be suppressed and electrons can be emitted favorably. In addition, in this emitter, the heater contacts the second section of the electron-emitting member. Due to this, it is possible to directly heat the electron-emitting member by the heater. Therefore, it is possible to stably heat the electron-emitting member by the heater compared with a case when, for example, the heater contacts the enclosing member and heats the electron-emitting member via the enclosing member. As a result, for example, even if used for a long time, fluctuations of electron emission characteristics can be suppressed. Furthermore, in this emitter, the minimum thickness of the enclosing member is 20 µm or more. Due to this, the function or effect of the generation of excessive electrons being suppressed by the enclosing member is obtained effectively. In addition, because the enclosing member is thick, it is possible to secure the strength of the enclosing member and improve structural stability. Accordingly, with this emitter, it is possible to suppress fluctuations in electron emission characteristics and to allow for the effective suppression of the generation of excessive electrons and the improvement of structural stability.

An emitter according to one aspect of the present disclosure may be [2] "the emitter according to [1], wherein an end section of the first section on the opposite side of the second section is formed in a tapered shape so as to become narrower towards the tip section thereof." In this case, electrons can be favorably emitted from the first section.

An emitter according to one aspect of the present disclosure may be [3] "the emitter according to [1] or [2], wherein the enclosing member is bonded to the electron-emitting member by a bonding material, and the bonding material is formed of the same material as the second material." In this case, it is possible to increase the bonding strength between the enclosing member and the electron-emitting member.

An emitter according to one aspect of the present disclosure may be [4] "the emitter according to [3], wherein the boundary with the second section in the first section is not enclosed by the enclosing member and is covered by the bonding material." In this case, it is possible to effectively suppress the generation of excessive electrons from areas other than the tip section of the first section.

An emitter according to one aspect of the present disclosure may be [5] "the emitter according to any one of [1] to [4], wherein in a width direction perpendicular to the prescribed direction, the width of the second section is wider than the width of the first section, and the electron source is fixed to the heater by sandwiching the second section with the heater along the width direction." In this case, it is possible to suppress the occurrence of damage to the electron source at the location fixed by the heater, making it possible to further improve structural stability.

An emitter according to one aspect of the present disclosure may be [6] "the emitter according to any one of [1] to [5], wherein the enclosing member is formed from a sintered body." In this case, it is possible to effectively suppress the generation of excessive electrons and to effectively improve structural stability.

### EFFECTS OF THE INVENTION

According to one aspect of the present disclosure, it is possible to provide an emitter in which fluctuations in electron emission characteristics are suppressed and in which the effective suppression of the generation of excessive electrons and the improvement of structural stability are possible.

### BRIEF DESCRIPTION OF DRAWINGS

FIG. 1 is a cross-sectional view of the emitter of the embodiment.
FIG. 2 is a cross-sectional view of the electron source and the heater.
FIG. 3 is a cross-sectional view of the electron source along the III-III line in FIG. 2.

### DESCRIPTION OF EMBODIMENT

Hereinafter, an embodiment of the present disclosure will be described in detail with reference to the drawings. In the following description, the same or equivalent elements will be designated by the same reference numbers, and redundant descriptions will be omitted.

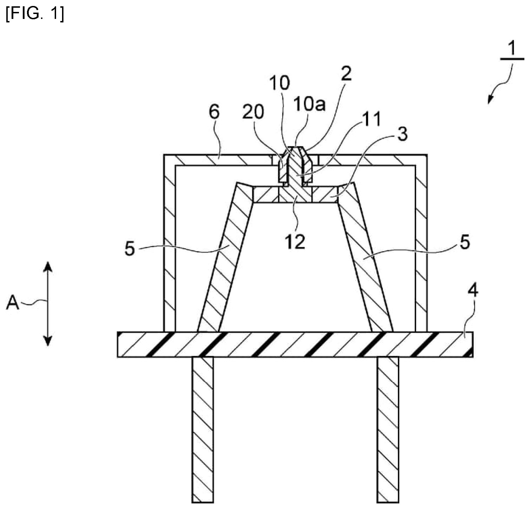

As shown in FIG. 1, the emitter 1 is provided with an electron source 2, a heater 3, an insulator 4, a pair of electrode pins 5, and a suppressor electrode 6. The electron source 2 emits electrons. Details of the electron source 2 will be described later. The electron source 2 is fixed to the heater 3 and is heated by the heater 3. The heater 3 is formed in a block shape, for example, from pyrolysis carbon, and generates heat when current is passed through the pair of electrode pins 5. The electrode pins 5 are provided so as to penetrate the insulator 4 and are connected to the heater 3. The suppressor electrode 6 is disposed around the electron source 2. The suppressor electrode 6 suppresses the lateral emission of electrons from the electron source 2. In the emitter 1, when the electron source 2 is heated by the current being passed to the heater 3, and a voltage is applied between the electron source 2 and an extraction electrode (not shown), electrons are output from the tip section of the electron source 2.

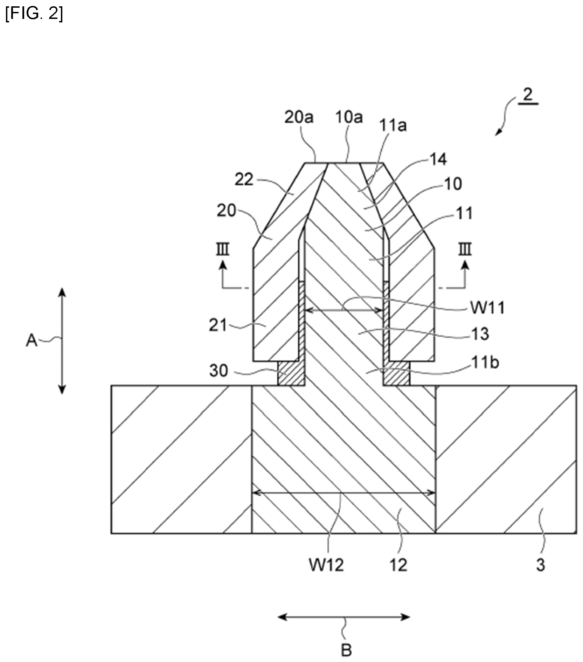

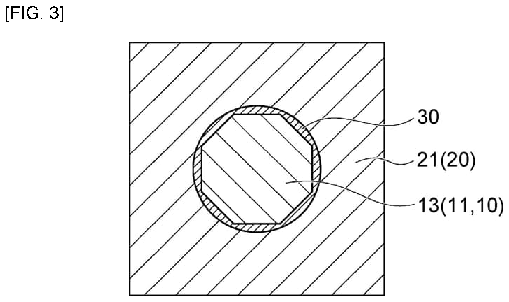

As shown in FIGs. 2 and 3, the electron source 2 comprises an electron-emitting member 10 and an enclosing member 20. The electron-emitting member 10 is made of a first material (electron-emitting material) having electron emission characteristics. The enclosing member 20 is made of a second material (electron-emission-restricting material) having a larger work function than that of the first material.

The first material is a material that, when heated, can emit electrons. The first material has a smaller work function than that of the second material. Examples of the first material include: rare earth borides such as lanthanum boride (LaB₆) and cerium boride (CeB₆); high melting point metals such as tungsten, tantalum, and hafnium, as well as their oxides, carbides, and nitrides; and precious metal-rare earth alloys such as iridium cerium. The work functions of these materials are as follows:
· Lanthanum boride (LaB₆): 2.8 eV;
· Cerium boride (CeB₆): 2.8 eV;
· Tantalum carbide: 3.2 eV; and
· Hafnium carbide: 3.3 eV

The second material has a greater work function than that of the first material. By enclosing the electron-emitting member 10 comprising the first material with the enclosing member 20 comprising the second material, the emission of electrons from the side surfaces of the electron-emitting member 10 is suppressed. The difference between the work function of the second material and the work function of the first material is preferably 0.5 eV or more, more preferably 1.0 eV or more, and even more preferably 1.6 eV or more.

The second material preferably contains a high melting point metal or its carbide, and preferably it contains at least one or more of metallic tantalum, metallic titanium, metallic zirconium, metallic tungsten, metallic molybdenum, metallic rhenium, tantalum carbide, titanium carbide, and zirconium carbide. The second material may contain at least one or more of boron carbide and graphite (carbon material). The second material may contain at least one or more of niobium, hafnium, and vanadium. As the second material, glassy carbon (for example, Glassy Carbon (product name, manufactured by Reiho Manufacturing Co., LTD.) may be used. The work functions of these materials are as follows:
· Metallic rhenium: 4.9 eV;
· Boron Carbide: 5.2 eV; and
· Graphite: 5.0 eV

The first material and the second material can be appropriately selected, for example, on the basis of the work functions and the strengths of the two and can be used in combination. Suitable examples of the first material include lanthanum boride (LaB₆), cerium boride (CeB₆), hafnium carbide, and iridium cerium. Suitable examples of the second material include metallic rhenium, boron carbide, and graphite (including glassy carbon). A portion of the materials that can be used as the first material can also be used as the second material. For example, materials with a work function of about 3.2 to 4.5 eV can be used as both the first material and the second material. Examples of such materials include metallic tungsten (work function: 4.5 eV), metallic tantalum (work function: 3.2 eV), and hafnium carbide (work function: 3.3 eV).

The electron-emitting member 10 has a first section 11 and a second section 12 integrally formed with the first section 11. In this example, the first section 11 has an octagonal columnar section 13 and a tapered section 14 formed in a tapered shape. The columnar section 13 extends along direction A (prescribed direction) from the second section 12. The tapered section 14, with respect to the columnar section 13, is provided on the opposite side of the second section 12 (upper side in FIG. 2), and forms an end section 11a of the first section 11 that is on the opposite side the second section 12. The tapered section 14 is formed in a tapered shape that becomes thinner towards the tip section thereof. The end surface 10a of the electron-emitting member 10 (tapered section 14) is an electron-emitting surface. The end surface 10a is a flat surface perpendicular, for example, to the direction A, and electrons are emitted from the end surface 10a along the direction A.

The second section 12 is formed in a wider shape than the columnar section 13. That is, in the direction B (width direction) perpendicular to the direction A, the width W12 of the second section 12 is wider than the width W11 of the first section 11. In this example, because the second section 12 is sandwiched by the heater 3 along the direction B, the electron source 2 is fixed to the heater 3. The heater 3 is in contact with the second section 12. In this example, the heater 3 is in contact with the entirety of the second section 12 in the direction A. The second section 12 is formed, for example, in a rectangular shape in a cross-section perpendicular to direction A.

The enclosing member 20 is formed in a substantially cylindrical shape, and when viewed from the direction A, encloses the first section 11 of the electron-emitting member 10. More specifically, the enclosing member 20 encloses the entirety of the first section 11 aside from the end section 11b (the boundary with the second section 12 in the first section 11) in the first section 11 on the side of the second section 12, without covering the end section 11b. That is, in the direction A, there is a gap between the enclosing member 20 and the second section 12 of the electron-emitting member 10. The end section 11b is covered by the bonding material 30 to be described below.

The enclosing member 20 has a first enclosing section 21 that encloses the columnar section 13 of the first section 11 and a second enclosing section 22 that encloses the tapered section 14 of the first section 11. In this example, the second enclosing section 22 also encloses the end section of the columnar section 13 on the tapered section 14 side. The first enclosing section 21 is formed in a cylindrical shape having, for example, a rectangular outer shape. The second enclosing section 22 is formed in a tapered shape becoming thinner toward the tip section thereof. The tapered angle of the outer surface of the second enclosing section 22 is greater than the tapered angle of the outer surface of the tapered section 14. Due to this, the thickness of the second enclosing section 22 becomes thinner toward the tip section side (opposite side of the second section 12).

The enclosing member 20 is formed, in this example, from a glassy carbon. More specifically, the enclosing member 20 is formed from a sintered body of glassy carbon formed by vacuum sintering a phenolic resin. The minimum thickness of the enclosing member 20 is 20 µm or more. In this example, the enclosing member 20 becomes thinnest at the tip section of the second enclosing section 22, and the thickness thereof is, for example, 40 µm. The thickness of the first enclosing section 21, for example, is about 150 µm. The minimum thickness of the enclosing member 20 is preferably 25 µm or more, and more preferably 30 µm or more.

The enclosing member 20 is bonded to the electron-emitting member 10 by the bonding material 30. The bonding material 30 is disposed between the first enclosing section 21 of the enclosing member 20 and the columnar section 13 of the first section 11 of the electron-emitting member 10. The bonding material 30 is also disposed between the first enclosing section 21 and the second section 12 of the electron-emitting member 10. Due to this, as explained above, the bonding material 30 covers the end section 11b of the first section 11 on the second section 12 side (the portion of the first section 11 that is exposed from the enclosing member 20). The bonding material 30, in this example, is formed from the same material (for example, glassy carbon) as the second material forming the enclosing member 20. More specifically, the bonding material 30 is formed from a glassy carbon sintered body formed by vacuum sintering a phenolic resin after being disposed in a prescribed location.

The end surface 20a of the enclosing member 20 (second enclosing section 22) is flush with the end surface 10a (electron-emitting surface) of the electron-emitting member 10. In addition, the side surfaces of the first section 11 of the electron-emitting member 10 are covered by the enclosing member 20 and the bonding material 30. In this manner, since the side surfaces of the first section 11 are not exposed, it is possible to suppress the emission of unnecessary electrons-that is, effectively suppressing the lateral emission of electrons is possible. For example, in order to obtain electrons with a greater current, the electron source 2 is heated at a high temperature of about 1550°C and a high electric field of several kV is applied to the electron source 2. When such a high electric field is applied, excessive electrons from areas other than the tip section of the electron source 2 can be generated. These excessive electrons, due to space charge effects, can lower the luminance of an electron beam from the tip section and can cause unnecessary heating of surrounding electrode components. In order to prevent these from happening, exposing only the electron-emitting section (end surface 10a of the electron-emitting member 10) of the electron source 2 and covering other surfaces with the enclosing member 20 and the bonding material 30 make it possible to obtain only a high luminance electron beam from the tip section.

By covering the side surfaces of the first section 11 of the electron-emitting member 10 with the enclosing member 20 and the bonding material 30, the effect of being able to suppress the occurrence of the phenomenon known as micro-discharge is achieved. That is, in heated electron emissions, electrons are emitted by heating the electron source at a high temperature. Along with this, the electron-emitting material evaporates and is affixed to the surrounding electrode components, and the resulting fibrous crystals are called whiskers. And when charges accumulate on the whiskers, micro-discharges occur. Micro-discharges destabilize the electron beams and can cause a drop in device performance. By covering the side surfaces of the first section 11 with the enclosing member 20 and the bonding material 30, the sublimated electron-emitting material is trapped by the enclosing member 20 and the bonding material 30, reducing the affixation amount to the surrounding electrode components, making it difficult for the micro-discharges to occur. Further, the enclosing member 20 and the bonding material 30 cover the entire circumference of the first section 11, and does not have a break or interval in the circumferential direction thereof, and this makes it possible to effectively suppress the lateral emission of electrons.

### [Functions and Effects]

In the emitter 1, the first section 11 of the electron-emitting member 10 is enclosed by the enclosing member 20, which is formed from the second material having a higher work function than that of the first material forming the electron-emitting member 10. Due to this, the generation of excessive electrons from areas other than the tip section of the first section 11 can be suppressed, and suitable electron emission is possible. In addition, in the emitter 1, the heater 3 is in contact with the second section 12 of the electron-emitting member 10. Due to this, it is possible to directly heat the electron-emitting member 10 with the heater 3. For this reason, for example, compared with the case when the heater contacts the enclosing member and heats the electron-emitting member via the enclosing member, it becomes possible to stably heat the electron-emitting member 10 with the heater 3. As a result, even if used for a long time, for example, it is possible to suppress fluctuations in the electron emission characteristics. That is, for example, when adopting the structure in which the heater contacts the enclosing member and heats the electron-emitting member via the enclosing member, if the emitter is continuously used for a long time (for example, two months), the contact state between the enclosing member and the electron-emitting member changes due to wear of the enclosing member caused by heating, for example, and output may fluctuate sporadically. This is thought to be because of heat conduction fluctuations from the heater to the electron-emitting member arising from changes in the contact state between the enclosing member and the electron-emitting member. In the emitter 1 according to this embodiment, since the heater 3 directly heats the electron-emitting member 10, it is possible to suppress the generation of such heat conduction fluctuations and it is possible to suppress fluctuations in electron emission characteristics. Furthermore, in the emitter 1, the minimum thickness of the enclosing member 20 is 20 µm or more. Due to this, the function and effect of suppressing the generation of excessive electrons is effectively achieved by the enclosing member 20. In addition, because the enclosing member 20 is thick, it is possible to secure the strength of the enclosing member 20, and this improves structural stability. Accordingly, with the emitter 1, it is possible to suppress fluctuations of the electron emission characteristics, effectively suppress the generation of excessive electrons, and improve structural stability.

The end section 11a (tapered section 14) of the first section 11 on the opposite side of the second section 12 is formed in a tapered shape that becomes thinner toward the tip section thereof. Due to this, it is possible to suitably emit electrons from the first section 11. Meanwhile, when the end section 11a is formed in a tapered shape, it is difficult to accurately form an electron emission suppression layer (for example, a layer having a thickness of 10 µm or less) by film formation on the end section 11a. Concerning this point, in the emitter 1 of the present embodiment, the enclosing member 20 enclosing the first section 11 is formed as a member (structure) having a thickness of 20 µm or more and is bonded to the electron-emitting member 10 by the bonding material 30. For this reason, since the enclosing member 20 is accurately formed, bonding to the electron-emitting member 10 is possible.

The enclosing member 20 is bonded to the electron-emitting member 10 by the bonding material 30, and the bonding material 30 is formed of the same material as the second material forming the enclosing member 20. Due to this, it is possible to increase the bonding strength between the enclosing member 20 and the electron-emitting member 10.

The end section 11b (the boundary of the first section 11 with the second section 12) of the first section 11 on the side of the second section 12 is not enclosed by the enclosing member 20 and is covered by the bonding material 30. Due to this, it is possible to effectively suppress the generation of excessive electrons from areas other than the tip section of the first section 11.

In the direction B (width direction), the width W12 of the second section 12 is wider than the width W11 of the first section 11, and the electron source 2 is fixed to the heater 3 by the second section 12 being sandwiched by the heater 3 along the direction B. Due to this, it is possible to prevent the occurrence of damage to the electron source 2 at the location fixed by the heater 3, and it is possible to further improve structural stability. In addition, since the width W12 of the second section 12 is wider than the width W11 of the first section 11, it becomes easier to grasp the second section 12, making it possible to improve handling properties.

The enclosing member 20 is formed from a sintered body. Due to this, it is possible to effectively suppress the generation of excessive electrons and it is possible to effectively improve structural stability.

The present disclosure is not limited to the above-described embodiment. For example, the materials and shapes of each of the structures are not limited to those described above, and a variety of materials and shapes can be employed.

The first section 11 of the electron-emitting member 10 may not have the tapered section 14, and, for example, may have the same cross-sectional shape across the entire length. The enclosing member 20 may not have the section formed in a tapered shape (second enclosing section 22) and, for example, may have the same cross-sectional shape across the entire length. In the above-described embodiment, the enclosing member 20 did not cover the end section 11b of the first section 11 on the second section 12 side, but the enclosing member 20 may cover the entirety of the first section 11 in the direction A. The bonding material 30 may be formed from a material different from the second material forming the enclosing member 20. The bonding material 30 does not necessarily need to be provided, and the enclosing member 20 may be fixed to the electron-emitting member 10 by a separate method. In the direction B, the width W12 of the second section 12 may be the same as the width W11 of the first section 11, and may be narrower than the width 11.

### REFERENCE SIGNS LIST

1: Emitter
2: Electron source
3: Heater
10: Electron-emitting member
11: First section
11a: End section
11b: End section
12: Second section
20: Enclosing member
30: Bonding material
A: Direction (prescribed direction)
B: Direction (width direction)
W11, W12: Width

## Claims

1. An emitter comprising:
an electron source; and
a heater for heating the electron source; wherein
the electron source comprises:
an electron-emitting member formed of a first material; and
an enclosing member formed of a second material having a greater work function than that of the first material,
the electron-emitting member has a first section and a second section formed integrally with the first section,
the enclosing member is fixed to the electron-emitting member and encloses the first section when viewed from a prescribed direction,
the enclosing member has a minimum thickness of 20 µm or more, and
the heater is in contact with the second section.

2. The emitter according to claim 1, wherein the end section of the first section on the opposite side of the second section is formed in a tapered shape that becomes thinner toward the tip section thereof.

3. The emitter according to claim 1 or 2, wherein the enclosing member is bonded to the electron-emitting member by a bonding material, and the bonding material is formed of the same material as the second material.

4. The emitter according to claim 3, wherein the boundary with the second section in the first section is not enclosed by the enclosing member and is covered by the bonding material.

5. The emitter according to claim 1 or 2, wherein in a width direction perpendicular to the prescribed direction, the width of the second section is wider than the width of the first section, and the electron source is fixed to the heater by sandwiching the second section with the heater along the width direction.

6. The emitter according to claim 1 or 2, wherein the enclosing member is formed from a sintered body.
